# EUROPÄISCHE PATENTSCHRIFT

(11) **EP 2 510 765 B1**
(45) Veröffentlichungstag und Bekanntmachung des Hinweises auf die Patenterteilung: **06.11.2013**
(21) Anmeldenummer: 10788276.3
(22) Anmeldetag: 25.11.2010
(51) Int. Cl.: H05K 9/00, H05K 7/20, H01L 23/552

(54) **ELEKTRONISCHES STEUERGERÄT**
ELECTRONIC CONTROL DEVICE
APPAREIL DE COMMANDE ÉLECTRONIQUE

(30) Priorität: 10.12.2009 DE 102009054517
(43) Veröffentlichungstag der Anmeldung: 17.10.2012
(73) Patentinhaber: Robert Bosch GmbH, 70442 Stuttgart (DE)
(72) Erfinder: WEEBER, Volker, 74348 Lauffen A. N. (DE); BARTH, Heinrich, 71229 Leonberg (DE); SCHERTLEN, Ralph, 70191 Stuttgart (DE)
(86) Internationale Anmeldenummer: PCT/EP2010/068171
(87) Internationale Veröffentlichungsnummer: WO 2011/069828

(56) Entgegenhaltungen:
- EP-A1- 1 233 666
- EP-A1- 1 796 449
- US-A1- 2009 002 949
- US-A1- 2009 146 269

## Beschreibung

### Stand der Technik

Die Erfindung betrifft ein Steuergerät nach dem Oberbegriff des Anspruchs 1. Derartige Geräte sind in vielfältigen Ausgestaltungen und für unterschiedliche Anwendungszwecke bekannt. Beim Einsatz derartiger Steuergeräte tritt in vielen Bereichen das Problem der Abschirmung von elektrischen und/oder magnetischen Feldern auf. Dabei ist es erforderlich, die elektronische Schaltung, Teile davon oder auch nur einzelne Bauelemente, vor elektrischen und/oder magnetischen Störeinstrahlungen zu schützen. Genauso kann es notwendig sein, die in einer elektronischen Schaltung entstehenden Störstrahlungen nicht nach außen gelangen zu lassen. Weiterhin kann es auch erforderlich sein, störeinstrahlempfindliche Bauelemente der Schaltung vor der Abstrahlung von störabstrahlenden Bauelementen dieser Schaltung zu schützen. Insbesondere Steuergeräte in Kraftfahrzeugen müssen daher im Hinblick auf ihre elektromagnetische Verträglichkeit (EMV) verbessert und optimiert werden.

Aus der DE 43 17 469 A1 ist ein Steuergerät bekannt, bei dem einzelne Schaltungsbauelemente oder die gesamte Schaltung mit einer geschlossenen Abschirmbox abgedeckt werden. Eine derartige Abschirmung ist jedoch sehr aufwändig und beansprucht große Volumina innerhalb des Steuergerätes.

### Offenbarung der Erfindung

Bei dem erfindungsgemäßen Steuergerät wird das Problem der Abschirmung von elektrischen und/oder magnetischen Feldern durch den Einsatz eines oder mehrerer elektrisch leitender Abschirmelemente gelöst, die jeweils zusammen mit der Leiterplatte und eventuell weiterer Bauteile einen faradayschen Käfig um die gesamte Schaltung, Gruppen von Bauelementen, oder einzelne Bauelemente bilden. Unter einem faradayschen Käfig versteht man im Allgemeinen eine allseitig geschlossene oder mit Öffnungen versehene Hülle aus einem elektrischen Leiter, deren Innenraum dadurch bei tiefen Frequenzen von äußeren elektrischen Feldern oder elektromagnetischen Wellen abgeschirmt ist.
Ein erfindungsgemäßes elektrisch leitendes Abschirmelement ist dazu beispielsweise aus Blech oder einem Drahtgeflecht hergestellt. Ein solches elektrisch leitendes Abschirmelement ist einfach und kostengünstig in der Herstellung und Montage und beansprucht wenig Platz innerhalb des Gehäuses. Somit wird ein kleiner und kompakter Aufbau möglich.

Bevorzugt ist das elektrisch leitende Abschirmelement als elektrisch leitendes Blechteil, insbesondere als Tiefziehteil, ausgebildet und besitzt beispielsweise eine hauben- oder topfartige Form. Es wird bevorzugt auf einem Metallrahmen befestigt, der auf der Leiterplatte angeordnet ist und die Bauelemente oder Bauelementgruppen umgibt, die von dem elektrisch leitenden Blechteil abgeschirmt werden.

In einer besonders bevorzugten Ausführung der Erfindung erfüllt das elektrisch leitende Abschirmelement zusätzlich zu seiner abschirmenden Wirkung noch andere Funktionen. Zum Beispiel kann das elektrisch leitende Abschirmelement zur Entwärmung von Leistungsbauelementen oder zur Bereitstellung von Massepotential dienen. In einer besonders bevorzugten Ausführung erfüllt das elektrisch leitende Abschirmelement mehrere dieser Funktionen.

In aktuellen Schaltungen für Steuergeräte kommen Bauelemente in der sogenannten Wafer-Level-Package Bauweise oder FlipChip Bauweise zum Einsatz. Um Fehlfunktionen dieser Bauelemente durch parasitäre Substratströme zu vermeiden, sollte an der Rückseite des jeweilige Bauelements. Massepotential anliegen, um Potentialverschiebungen innerhalb des Bauelements zu minimieren. Um die Anbindung an Massepotential zu erleichtern können derartige Bauelemente auf ihrer Rückseite eine metallisierte Schicht aufweisen.
Durch eine entsprechende Anbindung des elektrisch leitenden Abschirmelements, zum einen an diese Rückseitenmetallisierung des Bauelements und zum anderen an Massepotential, beispielsweise durch entsprechende Kontakte auf der Leiterplatte, kann die Masseanbindung des Wafer-Level-Package Bauelements einfach und ohne zusätzlichen Aufwand sichergestellt werden. Wenn das Bauelement keine Rückseitenmetallisierung aufweist, kann durch eine möglichst großflächige Anbindung der Rückseite des Bauteils an das elektrisch leitende Abschirmelement trotzdem der Massekontakt hergestellt werden.

Ein weiteres Problem, gerade bei einer kleinen, kompakten Bauweise, ist die Entwärmung von Leistungsbauelementen. Das elektrisch leitende Abschirmelement ist deshalb vorzugsweise so geformt, dass es in thermischem Kontakt zu mindestens einem Leistungsbauelement und in thermischem Kontakt zu dem umgebenden Gehäuse oder zu an dem Gehäuse angebrachten Kühlvorrichtungen steht. Dazu liegt das elektrisch leitende Abschirmelement vorzugsweise am Gehäuse an und weist ferner Vertiefungen oder Erhöhungen auf, die in ihrer Position mit der Position eines oder mehrerer Leistungsbauelemente korrespondieren und an die Leistungsbauelemente gedrückt werden. Die Wärme wird von dem elektrisch leitenden Abschirmelement an das Gehäuse abgeleitet. Auf diese Weise sind keine zusätzlichen Kühlelemente oder Wärmeführungselemente auf der Leiterplatte nötig.

Um eine möglichst wirkungsvolle Wärmeableitung zu erreichen, sind die Kontaktflächen zwischen dem elektrisch leitenden Abschirmelement und dem zugeordneten Leistungsbauelement und zwischen dem elektrisch leitenden Abschirmelement und dem Gehäuse so groß wie möglich ausgebildet. Eine derartige Kühlung ist besonders dann sehr wirkungsvoll, wenn wenigstens ein Leistungsbauelement in der sogenannten Slug-up Bauweise vorliegt. Ein derartiges Bauelement besitzt auf seiner der Leiterplatte abgewandten Seite ein Metallelement, das die Wärme aus dem Inneren des Bauelements an dessen Oberfläche ableitet, wo sie von dem elektrisch leitenden Abschirmelement aufgenommen wird. Dazu besteht das elektrisch leitende Abschirmelement vorzugsweise aus einem Material, das zusätzlich zu seiner elektrischen Leitfähigkeit auch eine hohe Wärmekapazität und eine hohe Wärmeleitfähigkeit besitzt. Geeignete Materialien sind beispielsweise Kupfer oder Aluminium.

Weitere Vorteile der Erfindung ergeben sich aus den Unteransprüchen und der Beschreibung.

### Zeichnungen

Figur 1 zeigt einen Schnitt durch ein Steuergerät nach einem ersten Ausführungsbeispiel der Erfindung.
Figur 2 zeigt einen Schnitt durch ein Steuergerät nach einem zweiten Ausführungsbeispiel der Erfindung.
Figuren 3a-c zeigen jeweils Schnitt und Draufsicht von Ausführungsbeispielen für elektrisch leitende Abschirmelemente.
Figur 4 zeigt ein Detail aus Figur 1.

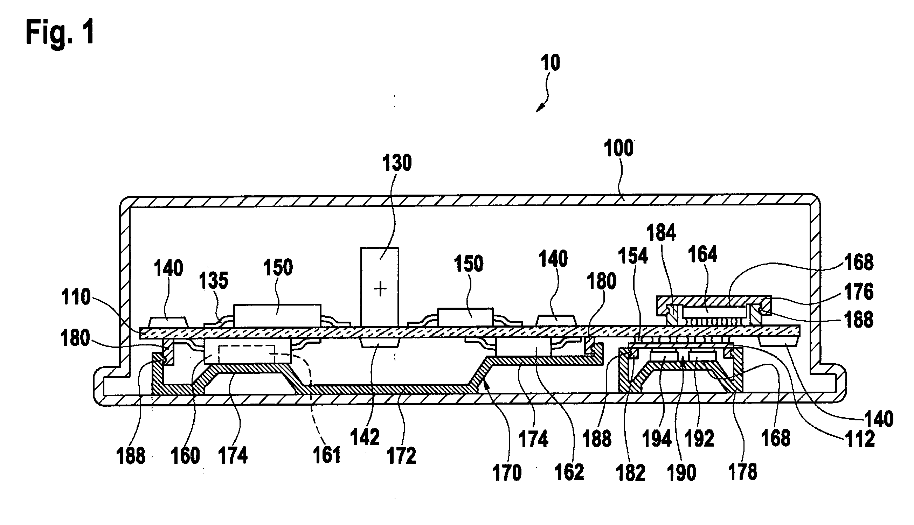

In Figur 1 ist ein Gehäuse 100 für ein Steuergerät 10 dargestellt, das in diesem Beispiel aus Metall besteht. Das Gehäuse 100 ist durch mindestens einen nicht dargestellten Deckel oder Stecker in sich abgeschlossen. Im Gehäuse 100 ist eine Leiterplatte 110 angeordnet. Die Leiterplatte 110 ist in diesem Ausführungsbeispiel beidseitig mit elektrischen und/oder elektronischen Bauelementen bestückt. Hierbei kann es sich beispielsweise um passive Bauelemente, wie den Kondensator 130 oder Widerstände 140, 142, oder um aktive Bauelemente, beispielsweise die Leistungsbauelemente 150,160, 162, 164, 192, 194 handeln. Die Bauelemente sind beispielsweise durch seitliche Anschlüsse 135 oder durch Lotkugeln 154 mit den auf der Leiterplatte verlaufenden, in der Zeichnung nicht sichtbaren Leiterbahnen kontaktiert, oder werden, wie am Beispiel des Kondensators 130, über nicht dargestellte Durchkontaktierungen mit der Leiterplatte verbunden.

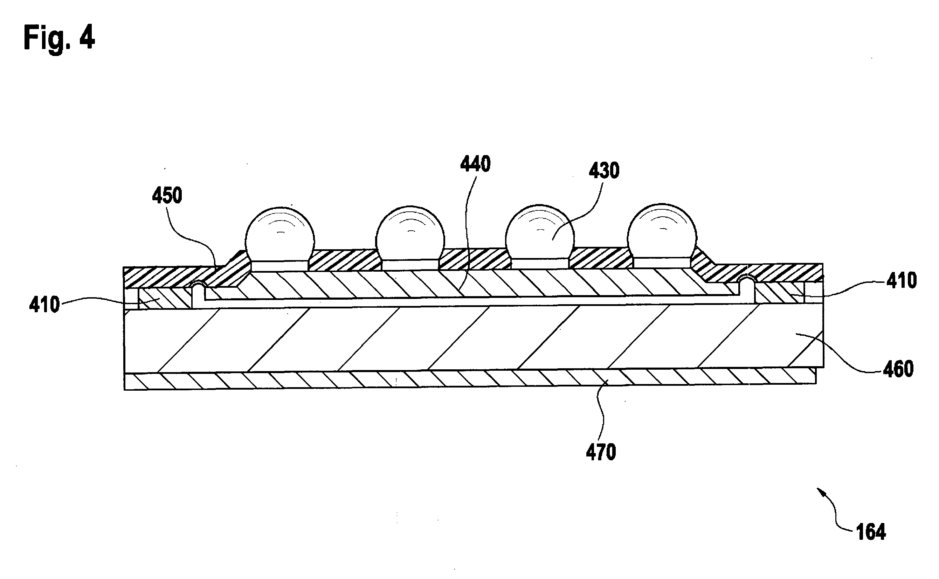

Auf der Oberseite der Leiterplatte sind ein Kondensator 130, Widerstände 140, sowie Leistungsbauelemente 150 angeordnet. Die Leistungsbauelemente 150 weisen nur eine geringe Leistung und darum auch nur eine geringe Wärmeentwicklung auf. Auf der Oberseite der Leiterplatte 110 ist ferner ein Bauelement 164 angeordnet, das in Wafer-Level-Package Bauweise aufgebaut ist und das in Figur 4 näher beschrieben wird.

Figur 4 stellt das elektronische Bauelement 164, das in Wafer-Level-Package Bauweise aufgebaut ist, im Detail dar. Das zentrale Element des Bauelements 164 ist der Chip 460. Zur Kontaktierung nach außen sind Lotkugeln 430 auf der der Leiterplatte zugewandten Oberfläche des Chips angeordnet, die über eine Kontaktschicht 440 mit Anschlussstellen 410 auf dem Chip 460 leitend verbunden sind. Zur elektrischen Isolation der Kontaktschicht 440 ist eine Polymerlage 450 auf der Kontaktschicht 440 angeordnet. Die Rückseite des Chips 460 ist mit einer metallischen Schicht 470 versehen, der sogenannten Rückseitenmetallisierung. Für die Funktionalität des Bauelements 164 kann es notwendig sein, dass die Rückseitenmetallisierung auf Massepotential liegt, da ansonsten parasitäre Ströme im Substrat des Chips 460 zu einer Fehlfunktion der Schaltung führen können.

Auf der Unterseite der Leiterplatte 110 sind ebenfalls verschiedene elektrische und/oder elektronische Bauelemente 142, 160, 162, 190 angeordnet. Bei den Bauelementen 160, 162, 192 und 194 handelt es sich um Leistungsbauelemente mit hoher Leistung und entsprechend hoher Wärmeentwicklung. Das Leistungsbauelement 160 ist in diesem Beispiel in sogenannter Slug-up Bauweise aufgebaut. Es weist ein Metallplättchen 161, einen sogenannten Heat-Slug, an seiner der Leiterplatte 110 abgewandten Seite auf. Dieser Heat-Slug dient zur Ableitung von Wärme aus dem Inneren des Leistungsbauelements 160 an dessen Oberfläche. Die Leistungsbauelemente 160 und 162 sowie passive Bauelement 142 bilden eine Gruppe von Bauelementen aus. Diese Gruppe muss in diesem Beispiel vor elektrischen und/oder magnetischen Störfeldern abgeschirmt werden.

Ebenfalls auf der Unterseite der Leiterplatte 110 ist ein sogenanntes Modul 190, auch Multi-Chip Module (MCM) genannt, angeordnet. Unter einem derartigen Modul versteht man im Allgemeinen eine kleine, mit Bauelementen bestückte Leiterplatte, die beispielsweise auf einer größeren Leiterplatte angeordnet und über Lotkugeln mit dieser kontaktiert sein kann. In dem vorliegenden Beispiel besteht das Modul 190 aus einer Leiterplatte 112, die kleiner und dünner ausgebildet ist als die Leiterplatte 110, und auf der zwei Leistungsbauelemente 192 und 194 angeordnet sind. Die Leistungsbauelemente 192 und 194 sind in Wafer-Level-Package Bauweise aufgebaut. Das Modul 190 ist über Lotkugeln 154 mit der Leiterplatte 110 kontaktiert.

Auf der Unterseite der Leiterplatte 110 ist ein Metallrahmen 180 angeordnet, der die Bauelementegruppe bestehend aus den Leistungsbauelementen 160 und 162 und dem passiven Bauelement 142 umgibt. An dem Metallrahmen 180 ist ein elektrisch leitendes Blechteil 170 mittels einer Klipsverbindung 188 befestigt. Dabei weist der Metallrahmen oder das elektrisch leitende Blechteil 170 eine umlaufende Nut auf in die ein an dem jeweils anderen Teil angebrachter Fortsatz nach Art einer Nut-Feder Verbindung eingreift und so das elektrisch leitende Blechteil 170 auf dem Metallrahmen 180 fixiert wird.
Der Metallrahmen 180, das elektrisch leitende Blechteil 170 und die Leiterplatte 110 bilden zusammen einen faradayschen Käfig für die Bauelemente 160, 162 und 142, wodurch sich eine wirkungsvolle Abschirmung von elektrischen und/oder magnetischen Störfeldern für diese Bauelemente 160, 162 und 142 ergibt. Das elektrisch leitende Blechteil 170 dient damit als Abschirmelement. Alternativ zu einer Klipsverbindung kann die Verbindung zwischen dem Metallrahmen 180 und dem elektrisch leitenden Blechteil 170 beispielsweise auch durch Schweißen oder Löten hergestellt werden.

Um zusätzlich eine zuverlässige und platzsparende Entwärmung der Leistungsbauelemente 160 und 162 zu erreichen, sind an dem elektrisch leitenden Blechteil 170 Bereiche 174 ausgebildet, die in thermischem Kontakt mit den Leistungsbauelementen 160, 162 stehen, sowie Bereiche 172, die in thermischem Kontakt mit dem Gehäuse 100 stehen. In den Leistungsbauelementen 160 entstehende Wärme wird damit von dem elektrisch leitenden Blechteil 170 aufgenommen, verteilt und an das Gehäuse 100 abgeleitet. Das elektrisch leitende Blechteil 170 ist dazu als Tiefziehteil ausgebildet, das flächige Bereiche 172 aufweist, die am Gehäuse 100 anliegen. Korrespondierend zu den Positionen der Leistungsbauelemente 160 und 162 sind Vertiefungen 174 in dem elektrisch leitenden Blechteil 170 angeordnet. Diese sind ebenfalls flächig ausgebildet und liegen an den Oberflächen der Leistungsbauelemente 160 und 162 an.

Auf der Oberseite der Leiterplatte 110 ist ein elektrisch leitender Metallrahmen 184 angeordnet, der das Bauelement 164 umgibt. Auf dem Metallrahmen 184 ist ein elektrisch leitendes Blechteil 176 befestigt. Die Befestigung erfolgt über eine Klipsverbindung 188 und ist somit elektrisch leitend. Alternativ zu einer Klipsverbindung kann die Verbindung zwischen dem Metallrahmen 184 und dem elektrisch leitenden Blechteil 176 beispielsweise auch durch Schweißen oder Löten hergestellt werden. Der Metallrahmen 184, das elektrisch leitende Blechteil 176 und die Leiterplatte 110 bilden zusammen einen faradayschen Käfig für das Bauelement 164, wodurch sich eine wirkungsvolle Abschirmung von elektrischen und/oder magnetischen Störfeldern ergibt. Das elektrisch leitende Blechteil 176 dient damit als Abschirmelement. Das Bauelement 164 ist in Wafer-Level-Package Bauweise aufgebaut und besitzt an seiner der Leiterplatte 110 abgewandten Seite eine Rückseitenmetallisierung 168. Die Rückseitenmetallisierung 168 befindet sich in leitendem elektrischen Kontakt mit dem elektrisch leitenden Blechteil 176. Der Metallrahmen 184 und damit auch das elektrisch leitende Blechteil 176 sind mit Massepotential verbunden. Somit liegt auch die Rückseitenmetallisierung 168 des Bauelements 164 auf Massepotential, wodurch unerwünschte Potentialverschiebungen im Substrat des Bauelements 164 minimiert werden. Da das elektrisch leitende Blechteil 176 nicht in thermischem Kontakt mit dem Gehäuse 100 steht, erfolgt in diesem Fall keine Ableitung von Wärme aus dem Bauelement 164 zum Gehäuse.

Auf der Leiterplatte 112 an der Unterseite der Leiterplatte 110 ist ebenfalls ein leitender Metallrahmen 182 angeordnet. Ein elektrisch leitendes Blechteil 178 ist auf dem Metallrahmen 182 mittels einer Klipsverbindung 188 befestigt. Alternativ zu einer Klipsverbindung kann die Verbindung zwischen dem Metallrahmen 182 und dem elektrisch leitenden Blechteil 178 beispielsweise auch durch Schweißen oder Löten hergestellt werden. Der Metallrahmen 182, das elektrisch leitende Blechteil 178 und die kleine Leiterplatte 112 bilden zusammen einen faradayschen Käfig für die Bauelemente 192 und 194, wodurch sich eine wirkungsvolle Abschirmung von elektrischen und/oder magnetischen Störfeldern für diese Bauelemente ergibt. Das elektrisch leitende Blechteil 178 dient damit als Abschirmelement. Der Metallrahmen 182 ist über die kleine Leiterplatte 112 mit Massepotential verbunden. Das elektrisch leitende Blechteil 178 ist so geformt, dass es in seinem mittleren Bereich an den beiden Bauelementen 192 und 194 anliegt und damit sowohl den Massekontakt für die Rückseitenmetallisierung 168 des Bauelements 192 herstellt, als auch im thermischen Kontakt mit beiden Bauelementen 192 und 194 steht. In seinem Randbereich ist das elektrisch leitende Blechteil 178 im Querschnitt etwa V-förmig ausgebildet und steht in thermischem Kontakt mit dem Gehäuse 100. In den Leistungsbauelementen 192 und 194 entstehende Wärme wird damit von dem elektrisch leitenden Blechteil 178 aufgenommen, in dem elektrisch leitenden Blechteil 178 verteilt und an das Gehäuse 100 abgeleitet. Damit kombiniert das elektrisch leitende Blechteil 178 die Funktionen der Abschirmung von elektrischen und/oder magnetischen Feldern, der Entwärmung von Leistungsbauelementen und der Massekontaktierung einer Rückseitenmetallisierung.

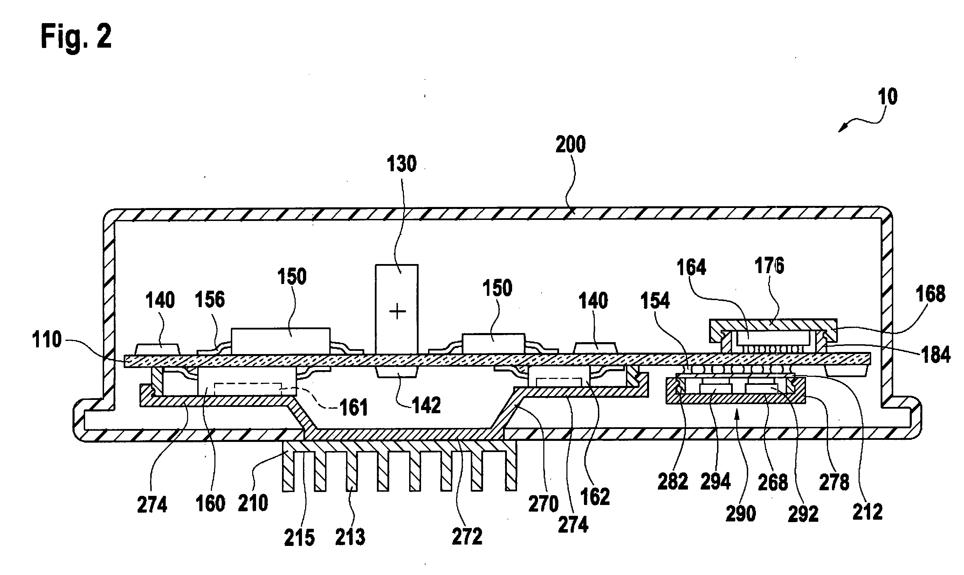

In Figur 2 ist ein zweites Ausführungsbeispiel der Erfindung dargestellt. Der Aufbau entspricht im Wesentlichen dem Beispiel aus Figur 1. Gleiche Bauteile sind mit den gleichen Bezugszeichen versehen. Das Gehäuse 200 besteht in diesem Beispiel aus Kunststoff. Es weist an seiner Unterseite eine Öffnung 215 auf, die von einem metallischen Kühlkörper 210 abgedeckt ist. Der Kühlkörper 210 bildet in bekannter Weise Kühlrippen 213 aus. Um eine effektive Kühlung der im Gehäuse 200 angeordneten Leistungsbauelemente mit hoher Leistung 160 und 162 zu erzielen, ist die Öffnung 215 und damit auch der Kühlkörper 210 in unmittelbarer Umgebung dieser Leistungsbauelemente 160 und 162 angeordnet.

Im Unterschied zur Figur 1 erfolgt die Entwärmung der Leistungsbauelemente 160 und 162 über ein elektrisch leitendes Blechteil 270, das in thermischem Kontakt zu den Leistungsbauelementen 160 und 162 steht und in thermischem Kontakt mit dem Kühlkörper 210 steht. Das elektrisch leitende Blechteil 270 ist dazu als Tiefziehteil ausgebildet, das flächige Bereiche 274 aufweist, die an den Leistungsbauelementen 160 und 162 anliegen. Korrespondierend zu der Position des Kühlkörpers ist eine Erhöhung 272 an dem elektrisch leitenden Blechteil 270 angeordnet. Diese ist ebenfalls flächig ausgebildet und liegt an dem Kühlkörper 210 an.

In dem Gehäuse 200 ist, ähnlich zur Figur 1, ein Modul 290 angeordnet. Das Modul besteht aus einer Leiterplatte 212 auf der zwei Leistungsbauelemente 290 und 292 angeordnet sind. Auf der Leiterplatte 212 ist ein leitender Metallrahmen 282 angeordnet. Ein elektrisch leitendes Blechteil 278 ist auf dem Metallrahmen 282 befestigt. Der Metallrahmen 282, das elektrisch leitende Blechteil 278 und die kleine Leiterplatte 212 bilden zusammen einen faradayschen Käfig für die Bauelemente 290 und 292 aus. Der Metallrahmen 282 ist ferner über die Leiterplatte 212 mit Massepotential verbunden. Das elektrisch leitende Blechteil 278 liegt an den beiden Bauelementen 292 und 294 an und stellt damit den Massekontakt für die Rückseitenmetallisierung 268 des Bauelements 292 her. Im Unterschied zur Figur 1 handelt es sich bei den Leistungsbauelementen 292 und 294 um Bauelemente mit geringer Leistung, so dass keine Entwärmung zu einem Kühlkörper über das elektrisch leitende Blechteil 278 notwendig ist. Es genügt, dass die Wärme in das Innere des Gehäuses 200 abgegeben wird.

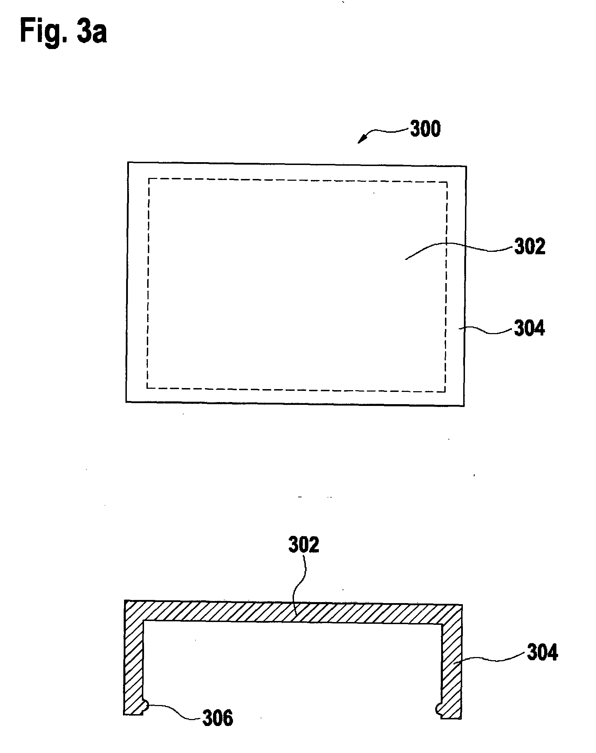

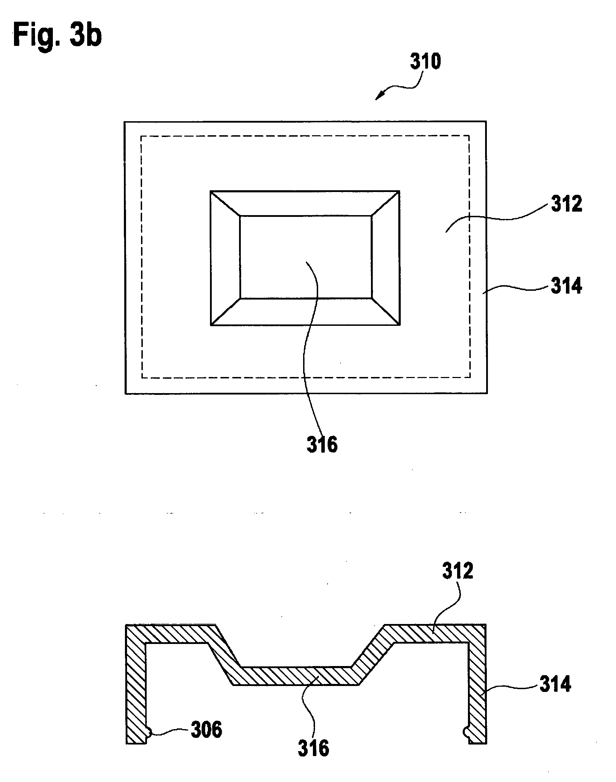

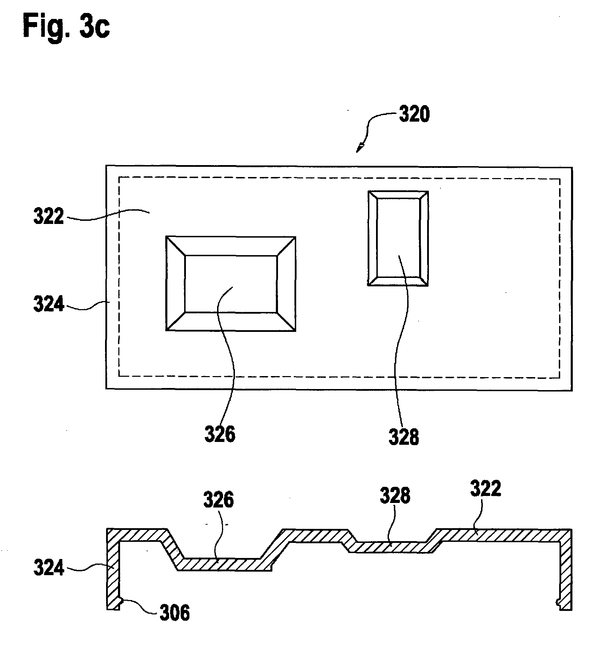

In Figur 3 sind drei Ausführungsbeispiele für erfindungsgemäße elektrisch leitende Abschirmelemente, die als Blechteile ausgeführt sind, jeweils in Draufsicht und im Querschnitt, dargestellt.

Figur 3a zeigt ein sehr einfach aufgebautes elektrisch leitendes Blechteil 300. Es ist im Wesentlichen topfförmig aufgebaut und besitzt einen flachen Deckelbereich 302, sowie einen Randbereich 304, der im Wesentlichen senkrecht zum Deckelbereich ausgebildet ist und um den Deckelbereich 302 herum verläuft. Der Randbereich 304 weist einen umlaufenden Fortsatz 306 auf, der für eine Klipsverbindung genutzt werden kann.

Figur 3b zeigt ein weiteres Beispiel für ein elektrisch leitendes Blechteil 310. Es besitzt einen Deckelbereich 312, sowie einen umlaufenden senkrecht zum Deckelbereich ausgebildeten Randbereich 314. Der Randbereich 314 weist einen umlaufenden Fortsatz 306 auf, der für eine Klipsverbindung genutzt werden kann. Der Deckelbereich 312 ist strukturiert und weist eine Vertiefung 316 auf. Diese Vertiefung ist geeignet einen thermischen und/oder elektrisch leitenden Kontakt zu einem oder mehreren darunter angeordneten elektronischen Bauelementen herzustellen.

Figur 3c zeigt eine Weiterführung des Beispiels aus Fig. 3b. Das dargestellte elektrisch leitende Blechteil 320 besitzt einen Deckelbereich 322, sowie einen umlaufenden senkrecht zum Deckelbereich ausgebildeten Randbereich 324. Der Randbereich 324 weist einen umlaufenden Fortsatz 306 auf, der für eine Klipsverbindung genutzt werden kann. Der Deckelbereich 322 ist strukturiert und weist zwei Vertiefungen 326 und 328 auf. Diese Vertiefung ist geeignet einen thermischen und/oder leitenden Kontakt zu jeweils einem oder mehreren darunter angeordneten elektronischen Bauelementen herzustellen. Die Vertiefungen 326 und 328 sind unterschiedlich tief und versetzt zueinander angeordnet. Die jeweilige Tiefe und Position ist der Bauhöhe und der Position der zugeordneten elektronischen Bauelemente angepasst.

Die Vertiefungen in den Figuren 3b und 3c sind möglichst flächig ausgebildet um eine große Kontaktfläche zwischen dem elektrisch leitenden Blechteil und darunter vorgesehen elektronischen Bauelementen zu gewährleisten. Die Vertiefungen sind in den gezeigten Beispielen rechteckig ausgebildet, jedoch ist jede andere Form ebenfalls denkbar, z.B. rund, elliptisch oder L-förmig. Zusätzlich oder alternativ ist es auch möglich Erhöhungen statt Vertiefungen vorzusehen. Der thermische Kontakt kann durch Berührung oder durch ein Wärmeleitmedium, wie beispielsweise eine Wärmeleitpaste sichergestellt werden.

## Patentansprüche

1. Elektronisches Steuergerät (10), bestehend aus einem Gehäuse (100, 200), in dem mindestens eine Leiterplatte (110, 112) angeordnet ist, wobei auf der Leiterplatte (110, 112) mindestens ein elektronisches Bauelement (150, 160, 162, 164, 192, 194) angeordnet ist, wobei das elektronische Steuergerät (10) Mittel zum Abschirmen von elektrischen und/oder magnetischen Feldern aufweist,
wobei die Mittel zum Abschirmen von elektrischen und/oder magnetischen Feldern mindestens ein elektrisch leitendes Abschirmelement (170, 176, 178, 270, 278, 300, 310, 320) umfassen, das so angeordnet ist, dass zumindest das elektrisch leitende Abschirmelement (170, 176, 178, 270, 278, 300, 310, 320) und die Leiterplatte (110, 112) einen faradayschen Käfig für mindestens ein zugeordnetes elektronisches Bauelement (160, 162, 164, 192, 194) ausbilden, und wobei das elektrisch leitende Abschirmelement (176, 178, 278) mit einem Massepotential verbunden ist, **dadurch gekennzeichnet, dass**
mindestens ein elektronisches Bauelement (164, 192, 292) mit seiner Rückseite in leitendem Kontakt mit dem mindestens einen elektrisch leitenden Abschirmelement (176, 178, 278) steht, wobei das elektrisch leitende Abschirmelement (170, 270, 178) mindestens einen ersten Bereich (172, 272) aufweist, der in thermischem Kontakt mit dem Gehäuse (100) oder einem an dem Gehäuse angeordneten Kühlkörper (210) steht, und mindestens einen zweiten Bereich (174, 274) aufweist, der in thermischen Kontakt zu mindestens einem zugeordneten Leistungsbauelement (160, 162, 192, 194) steht.

2. Elektronisches Steuergerät (10) nach Anspruch 1, **dadurch gekennzeichnet, dass** auf der Leiterplatte (110, 112) mindestens ein Metallrahmen (180, 182, 184) um mindestens ein elektronisches Bauelement (160, 162, 164, 192, 194) angeordnet ist, an dem das elektrisch leitende Abschirmelement (170, 176, 178, 270, 278) befestigt ist.

3. Elektronisches Steuergerät (10) nach einem der vorangehenden Ansprüche 1 oder 2, **dadurch gekennzeichnet, dass** mindestens ein elektrisch leitendes Abschirmelement (170, 176, 178, 270, 278) mittels einer Klipsverbindung (188) befestigt ist oder verlötet oder verschweißt ist.

4. Elektronisches Steuergerät (10) nach einem der vorangehenden Ansprüche 1 bis 3, **dadurch gekennzeichnet, dass** das Gehäuse (200) eine Öffnung (215) aufweist, die von einem an dem Gehäuse angeordneten Kühlkörper (210) verschlossen wird.

5. Elektronisches Steuergerät (10) nach Anspruch 1, **dadurch gekennzeichnet, dass** die zweiten Bereiche (174, 328) als Vertiefungen (316, 326, 328) oder Erhöhungen ausgebildet sind, deren Positionen mit den Positionen der ihnen zugeordneten Leistungsbauelementen (160, 162, 192, 194) auf der Leiterplatte korrespondieren.

6. Elektronisches Steuergerät (10) nach einem der vorangehenden Ansprüche 1 bis 5, **dadurch gekennzeichnet, dass** die zweiten Bereiche (174, 274) mit den jeweiligen Bauhöhen der zugeordneten Leistungsbauelemente (160, 162, 192, 194) korrespondieren.

7. Elektronisches Steuergerät (10) nach einem der vorangehenden Ansprüche 1 bis 6, **dadurch gekennzeichnet, dass** mindestens ein Leistungsbauelement (160) ein Heat-Slug Element (161) auf seiner der Leiterplatte abgewandten Seite aufweist.

8. Elektronisches Steuergerät (10) nach einem der Ansprüche 1 bis 7, **dadurch gekennzeichnet, dass** das elektronisches Bauelement (164, 192, 292) an seiner Rückseite eine Rückseitenmetallisierung (168, 268) aufweist.

## Claims

1. Electronic control device (10) comprising a housing (100, 200) in which at least one printed circuit board (110, 112) is arranged, wherein at least one electronic component (150, 160, 162, 164, 192, 194) is arranged on the printed circuit board (110, 112), wherein the electronic control device (10) has means for shielding against electrical and/or magnetic fields,
wherein the means for shielding against electrical and/or magnetic fields comprise at least one electrically conductive shielding element (170, 176, 178, 270, 278, 300, 310, 320) which is arranged such that at least the electrically conductive shielding element (170, 176, 178, 270, 278, 300, 310, 320) and the printed circuit board (110, 112) form a Faraday cage for at least one associated electronic component (160, 162, 164, 192, 194), and wherein the electrically conductive shielding element (176, 178, 278) is connected to an earth potential,
**characterized in that**
at least one electronic component (164, 192, 292), by way of its rear face, is in conductive contact with the at least one electrically conductive shielding element (176, 178, 278), wherein the electrically conductive shielding element (170, 270, 178) has at least one first region (172, 272) which is in thermal contact with the housing (100) or a heat sink (210) which is arranged on the housing, and has at least one second region (174, 274) which is in thermal contact with at least one associated power component (160, 162, 192, 194).

2. Electronic control device (10) according to Claim 1, **characterized in that**, on the printed circuit board (110, 112), at least one metal frame (180, 182, 184) is arranged around at least one electronic component (160, 162, 164, 192, 194) to which the electrically conductive shielding element (170, 176, 178, 270, 278) is attached.

3. Electronic control device (10) according to either of the preceding Claims 1 and 2, **characterized in that** at least one electrically conductive shielding element (170, 176, 178, 270, 278) is attached by means of a clip connection (188) or is soldered or welded.

4. Electronic control device (10) according to one of the preceding Claims 1 to 3, **characterized in that** the housing (200) has an opening (215) which is closed by a heat sink (210) which is arranged on the housing.

5. Electronic control device (10) according to Claim 1, **characterized in that** the second regions (174, 328) are in the form of recesses (316, 326, 328) or raised portions, the positions of said recesses and raised portions corresponding to the positions of their associated power components (160, 162, 192, 194) on the printed circuit board.

6. Electronic control device (10) according to one of the preceding Claims 1 to 5, **characterized in that** the second regions (174, 274) correspond to the respective overall heights of the associated power components (160, 162, 192, 194).

7. Electronic control device (10) according to one of the preceding Claims 1 to 6, **characterized in that** at least one power component (160) has a heat slug element (161) on its side which is averted from the printed circuit board.

8. Electronic control device (10) according to one of Claims 1 to 7, **characterized in that** the electronic component (164, 192, 292) has a rear-face metallization (168, 268) on its rear face.

## Revendications

1. Appareil électronique de commande (10) constitué d'un boîtier (100, 200) dans lequel au moins une carte de circuit (110, 112) est disposée,
au moins un composant électronique (150, 160, 162, 164, 192, 194) étant disposé sur la carte de circuit (110, 112),
l'appareil électronique de commande (10) présentant des moyens de blindage vis-à-vis des champs électriques et/ou des champs magnétiques,
les moyens de blindage vis-à-vis des champs électriques et/ou des champs magnétiques comprenant au moins un élément de blindage (170, 176, 178, 270, 278, 300, 310, 320) électriquement conducteur disposé de telle sorte qu'au moins l'élément de blindage (170, 176, 178, 270, 278, 300, 310, 320) électriquement conducteur et la carte de circuit (110, 112) forment une cage de Faraday pour au moins un composant électronique (160, 162, 164, 192, 194) associé,
l'élément de blindage (176, 178, 278) électriquement conducteur étant raccordé à un potentiel de masse,
**caractérisé en ce que**
au moins un composant électronique (164, 192, 292) est en contact conducteur par son côté arrière avec le ou les éléments de blindage (176, 178, 278) électriquement conducteur,
**en ce que** l'élément de blindage (170, 270, 178) électriquement conducteur présente au moins une première partie (172, 272) en contact thermique avec le boîtier (100) et/ou avec un corps de refroidissement (210) disposé sur le boîtier et présente au moins une deuxième partie (174, 274) en contact thermique avec le ou les composants de puissance (160, 162, 192, 194) associés.

2. Appareil électronique de commande (10) selon la revendication 1, **caractérisé en ce qu'**au moins un cadre métallique (180, 182, 184) et au moins un composant électronique (160, 162, 164, 192, 194) sur lequel l'élément de blindage (170, 176, 178, 270, 278) électriquement conducteur est fixé sont disposés sur la carte de circuit (110, 112).

3. Appareil électronique de commande (10) selon l'une des revendications 1 ou 2 qui précèdent, **caractérisé en ce qu'**au moins un élément de blindage (170, 176, 178, 270, 278) électriquement conducteur est fixé au moyen d'une liaison encliquetable (188), est brasé ou est soudé.

4. Appareil électronique de commande (10) selon l'une des revendications 1 à 3 qui précèdent, **caractérisé en ce que** le boîtier (200) présente une ouverture (215) fermée par un corps de refroidissement (210) disposé sur le boîtier.

5. Appareil électronique de commande (10) selon la revendication 1, **caractérisé en ce que** les deuxièmes parties (174, 328) sont configurées comme creux (316, 326, 328) ou saillies dont les positions correspondent aux positions des composants de puissance (160, 162, 192, 194) qui leur sont associés sur la carte de circuit.

6. Appareil électronique de commande (10) selon l'une des revendications 1 à 5 qui précèdent, **caractérisé en ce que** les deuxièmes parties (174, 274) correspondent à la hauteur de montage des composants de puissance (160, 162, 192, 194) qui leur sont associés.

7. Appareil électronique de commande (10) selon l'une des revendications 1 à 6 qui précèdent, **caractérisé en ce qu'**au moins un composant de puissance (160) présente un élément (161) dit "Heat-Slug" sur son côté non tourné vers la carte de circuit.

8. Appareil électronique de commande (10) selon l'une des revendications 1 à 7, **caractérisé en ce que** le composant électronique (164, 192, 292) présente sur son côté dorsal une métallisation (168, 268) de côté dorsal.
